# EUROPEAN PATENT APPLICATION

(11) **EP 2 259 337 A1**
(43) Date of publication of application: **08.12.2010**
(21) Application number: 08739040.7
(22) Date of filing: 27.03.2008
(51) Int. Cl.: H01L 31/068, H01L 31/0236

(54) **PHOTOVOLATIC POWER DEVICE AND METHOD FOR MANUFACTURING THE SAME**

(71) Applicant: Mitsubishi Electric Corporation, Tokyo 100-8310 (JP)
(72) Inventor: ISHIHARA, Takashi, Tokyo 100-8310 (JP); NISHIMURA, Kunihiko, Tokyo 100-8310 (JP)
(74) Representative: Pfenning, Meinig & Partner GbR
(86) International application number: PCT/JP2008/055911
(87) International publication number: WO 2009/118861

(57) **Abstract**

To obtain a photovoltaic power device that can improve the photoelectric conversion efficiency more than that of conventional techniques without degrading the efficiency of extracting a photocurrent to an external circuit.

A photovoltaic power device includes a P-type silicon substrate 101, a low-resistance N-type diffusion layer 102L diffused with an N-type impurity in a first concentration formed at a light-incidence surface side, grid electrodes 111 formed on the low-resistance N-type diffusion layer 102L, a P+ layer 110 formed on a back surface, and a back surface electrode formed on the P+ layer 110. The photovoltaic power device has concave portions 106 provided at a predetermined interval to reach the silicon substrate 101 from an upper surface of the low-resistance N-type diffusion layer 102L, and an upper surface of a region between adjacent concave portions 106 includes the low-resistance N-type diffusion layer 102L. A high-resistance N-type diffusion layer 102H diffused with an N-type impurity in a second concentration, which is lower than the first concentration, is formed in a range of a predetermined depth from a formation surface of the concave portions 106.

## Description

### TECHNICAL FIELD

The present invention relates to a photovoltaic power device and a manufacturing method thereof.

### BACKGROUND ART

To improve the performance of photovoltaic power devices such as solar batteries, as to how efficiently sunlight is to be taken into inside of a photovoltaic power device is an important factor. Therefore, conventionally, a texture structure having intentionally formed a fine uneven concavo-convex shape in a size of dozens of nanometers to dozens of micrometers on a surface of a light incidence side is manufactured. In this texture structure, light once reflected on a surface is made to enter the surface again to take more sunlight into the inside of the photovoltaic power device, thereby increasing a generated current and improving its photoelectric conversion efficiency.

As a method of forming a texture structure on a solar battery substrate, when a substrate is a monocrystalline silicon (Si) substrate, an anisotropic etching process using a crystal orientation of an alkaline aqueous solution such as a sodium hydroxide solution and a potassium hydroxide solution having crystal orientation dependency in etching speed is widely used (see, for example, Patent Document 1). For example, when an anisotropic etching process is performed on a substrate surface having an (100) surface orientation on the surface, a pyramid-shaped texture having an exposed (111) surface is formed.

However, in the case of a polycrystalline silicon substrate, according to a method of performing an anisotropic etching process by using an alkaline aqueous solution, a crystal surface orientation of crystal particles constituting a substrate surface is not aligned, and the anisotropic etching process itself using a alkaline aqueous solution has an etching rate greatly different depending on the crystal surface. Therefore, a texture structure can be manufactured only partially. Because of this problem, there is a limit in reducing the reflection ratio in the case of the polycrystalline silicon substrate. For example, when the reflection ratio for a wavelength of 628 nanometers is considered, the reflection ratio is about 36% for silicon of which surface is mirror-polished, and the reflection ratio is about 15% for a monocrystalline silicon substrate of a (100) surface when it is wet-etched. The reflection ratio is about 27% to 30% for a polycrystalline silicon substrate when it is wet-etched.

As a method of forming a texture structure on the whole surface without depending on a crystal surface orientation, a technique of mixed acid etching using an etching mask has been proposed (see, for example, Patent Document 2). As a manufacturing method of an etching mask, there can be used a method according to lithography, which is used in a semiconductor process, and a method of mixing fine particles of a low etching resistance in a solution of an etching resistance material and coating this mixture onto a substrate surface.

A dopant liquid containing an N-type diffusion source is coated on a surface of a P-type silicon substrate on which a texture structure is formed in the above manner, and the dopant liquid is subjected to thermal treatment and then diffused, thereby forming a high-concentration N-type diffusion layer having a high concentration of phosphorus on a surface of the texture structure. Grid electrodes made of a metal such as silver arranged in a comb shape at a predetermined position on a texture structure of the silicon substrate, and bus electrodes made of a metal such as silver for collecting a current from the grid electrodes are formed, and back surface electrodes made of a metal such as aluminum and silver are formed on a back surface, thereby forming solar batteries (see, for example, Patent Document 3).

Patent Document 1: Japanese Patent Application Laid-open No. H10-70296
Patent Document 2: Japanese Patent Application Laid-open No. 2003-309276
Patent Document 3: Japanese Patent Application Laid-open No. 2005-116559

### DISCLOSURE OF INVENTION

### PROBLEM TO BE SOLVED BY THE INVENTION

A texture structure side of a silicon substrate needs to be diffused with an impurity in a high concentration to have satisfactory electrical contact with grid electrodes made of a metal and to efficiently extract a photocurrent generated within a photovoltaic power device to an external circuit. However, to obtain satisfactory photovoltaic power, preferably, the impurity concentration diffused within the silicon substrate at the texture structure side is controlled to be at or below a predetermined level. Therefore, because a photovoltaic power device with a structure using the conventional techniques described above efficiently extracts a photocurrent generated in the photovoltaic power device to an external circuit while compromising its photoelectric conversion efficiency. Therefore, a technique of improving the photoelectric conversion efficiency more than that of conventional techniques without degrading the efficiency of extracting a photocurrent to an external circuit has been desired.

The present invention has been achieved in view of the above circumstances, and an object of the present invention is to provide a photovoltaic power device that can improve the photoelectric conversion efficiency more than that of conventional techniques without degrading the efficiency of extracting a photocurrent to an external circuit and to provide a manufacturing method thereof.

### MEANS FOR SOLVING PROBLEM

In order to attain the above object, in a photovoltaic power device including a first-conductivity-type semiconductor substrate, a first diffusion layer diffused with a second-conductivity-type impurity in a first concentration formed at a light-incidence surface side of the semiconductor substrate, comb-shaped grid electrodes and bus electrodes that connect the grid electrodes formed on the first diffusion layer, a second diffusion layer of a first-conductivity type formed on a back surface facing a light incidence surface of the semiconductor substrate, and a back surface electrode formed on the second diffusion layer, the photovoltaic power device of the present invention has concave portions provided at a predetermined interval to reach the semiconductor substrate from an upper surface of the first diffusion layer. Additionally, in the photovoltaic power device of the present invention, an upper surface of a region between the concave portions adjacent with each other includes the first diffusion layer, and a third diffusion layer diffused with a second-conductivity-type impurity in a second concentration, which is lower than the first concentration, is formed in a range of a predetermined depth from a formation surface of the concave portions.

### EFFECT OF THE INVENTION

According to the present invention, the first diffusion layer of a low resistance is formed at a light-receiving surface side of a silicon substrate, and concave portions are provided at a predetermined interval such that not the whole of the first diffusion layer is removed, and the third diffusion layer having an impurity concentration lower than that of the first diffusion layer is provided in a range of a predetermined depth from a surface of the concave portions. Therefore, by decreasing the reflection ratio of incident sunlight, a photoelectric conversion can be efficiently performed in the third diffusion layer within the concave portions, and a photocurrent generated by the photoelectric conversion can be caused to reach surface electrodes via the first diffusion layer on a silicon substrate surface having a low resistance. Because the photocurrent is collected by surface electrodes through the first diffusion layer having a low resistance, a resistance loss can be suppressed, a forming area of the surface electrodes can be reduced by expanding an interval between the surface electrodes, and more sunlight can be taken into the silicon substrate. As a result, the photoelectric conversion efficiency can be improved more than that of conventional techniques without degrading the efficiency of extracting a photocurrent to an external circuit.

### BRIEF DESCRIPTION OF DRAWINGS

[Fig. 1-1] Fig. 1-1 is a top view of a photovoltaic power device.
[Fig. 1-2] Fig. 1-2 is a back view of the photovoltaic power device.
[Fig. 1-3] Fig. 1-3 is a cross-sectional view along A-A in Fig. 1-2.
[Fig. 2] Fig. 2 is a partial enlarged perspective view of a grid electrode periphery of the photovoltaic power device shown in Figs. 1-1 to 1-3.
[Fig. 3] Fig. 3 is a cross-sectional view along B-B in Fig. 2.
[Fig. 4-1] Fig. 4-1 is a cross-sectional view of an example of a structure of a grid electrode periphery of the photovoltaic power device according to the first embodiment.
[Fig. 4-2] Fig. 4-2 is an example of a structure of a grid electrode periphery of a conventional photovoltaic power device.
[Fig. 5-1] Fig. 5-1 is a schematic perspective view of an example of a process procedure of a manufacturing method of a photovoltaic power device according to the first embodiment (part 1).
[Fig. 5-2] Fig. 5-2 is a schematic perspective view of an example of a process procedure of the manufacturing method of a photovoltaic power device according to the first embodiment (part 2).
[Fig. 5-3] Fig. 5-3 is a schematic perspective view of an example of a process procedure of the manufacturing method of a photovoltaic power device according to the first embodiment (part 3).
[Fig. 5-4] Fig. 5-4 is a schematic perspective view of an example of a process procedure of the manufacturing method of a photovoltaic power device according to the first embodiment (part 4).
[Fig. 5-5] Fig. 5-5 is a schematic perspective view of an example of a process procedure of the manufacturing method of a photovoltaic power device according to the first embodiment (part 5).

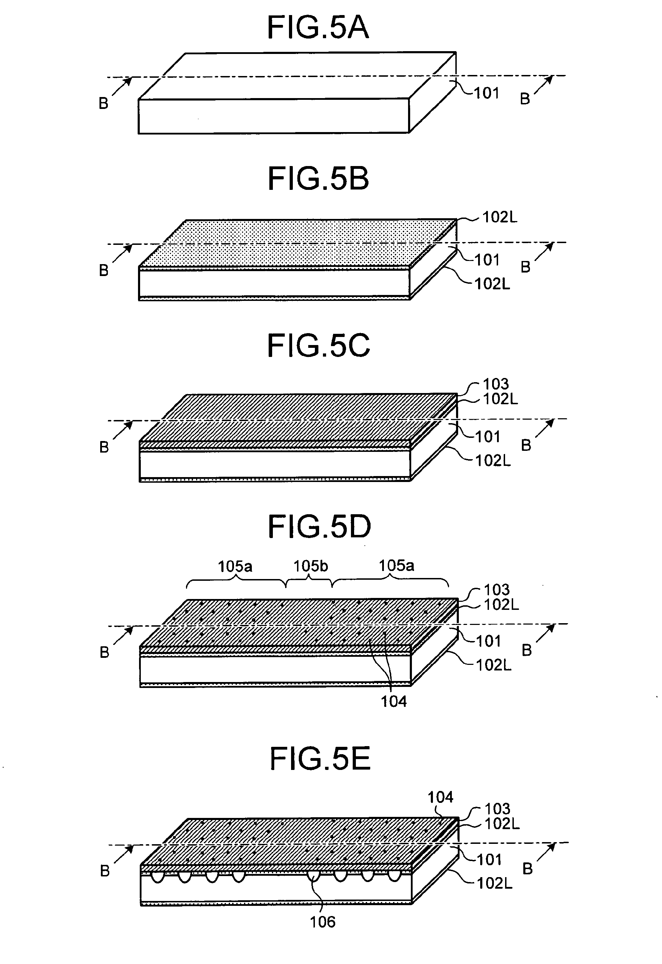

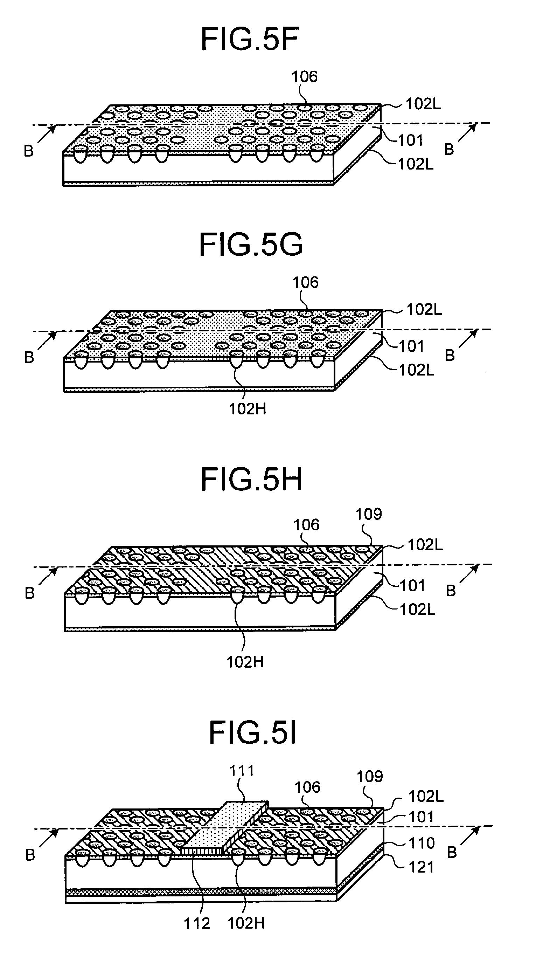

[Fig. 5-6] Fig. 5-6 is a schematic perspective view of an example of a process procedure of the manufacturing method of a photovoltaic power device according to the first embodiment (part 6).
[Fig. 5-7] Fig. 5-7 is a schematic perspective view of an example of a process procedure of the manufacturing method of a photovoltaic power device according to the first embodiment (part 7).
[Fig. 5-8] Fig. 5-8 is a schematic perspective view of an example of a process procedure of the manufacturing method of a photovoltaic power device according to the first embodiment (part 8).
[Fig. 5-9] Fig. 5-9 is a schematic perspective view of an example of a process procedure of the manufacturing method of a photovoltaic power device according to the first embodiment (part 9).
[Fig. 6-1] Fig. 6-1 is a cross-sectional view along B-B in Figs. 5-1.
[Fig. 6-2] Fig. 6-2 is a cross-sectional view along B-B in Figs. 5-2.
[Fig. 6-3] Fig. 6-3 is a cross-sectional view along B-B in Figs. 5-3.
[Fig. 6-4] Fig. 6-4 is a cross-sectional view along B-B in Figs. 5-4.
[Fig. 6-5] Fig. 6-5 is a cross-sectional view along B-B in Figs. 5-5.
[Fig. 6-6] Fig. 6-6 is a cross-sectional view along B-B in Figs. 5-6.

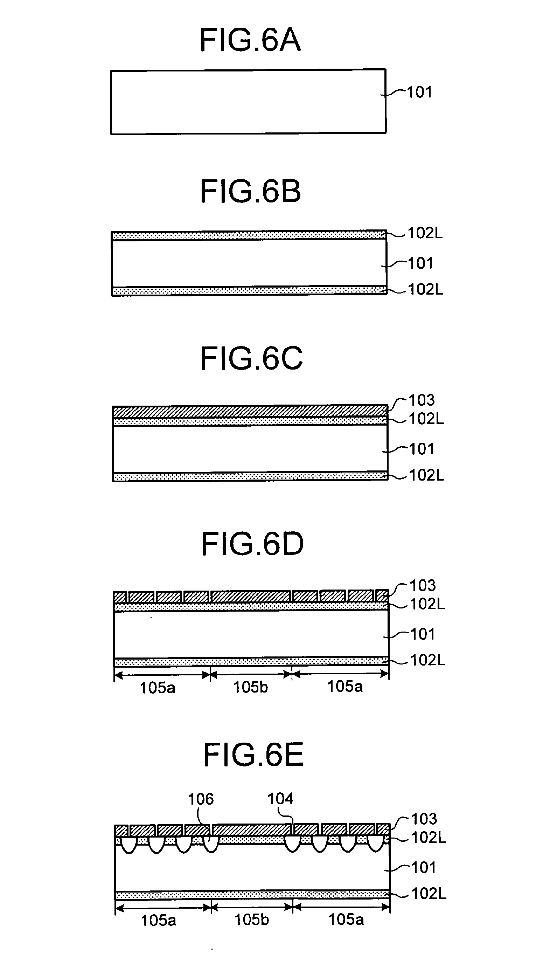

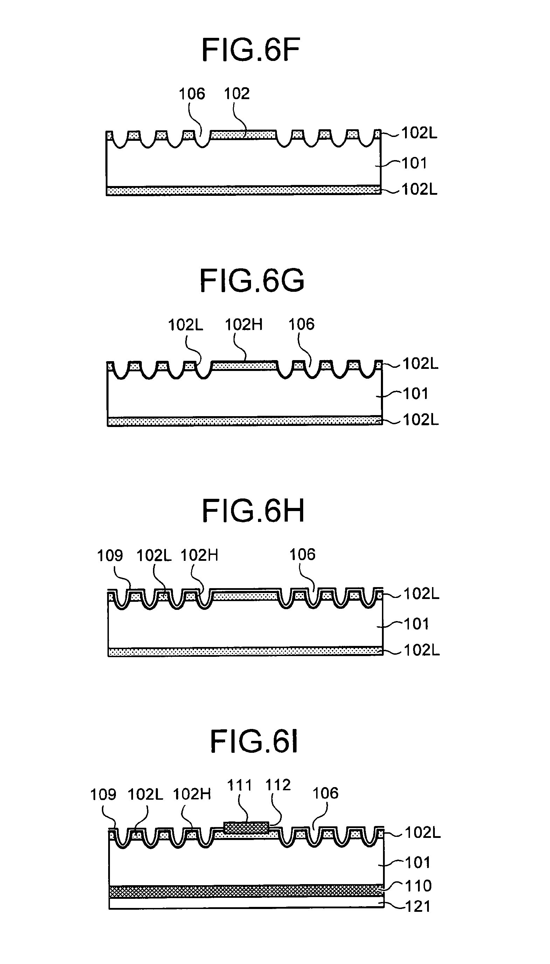

[Fig. 6-7] Fig. 6-7 is a cross-sectional view along B-B in Figs. 5-7.
[Fig. 6-8] Fig. 6-8 is a cross-sectional view along B-B in Figs. 5-8.
[Fig. 6-9] Fig. 6-9 is a cross-sectional view along B-B in Figs. 5-9.

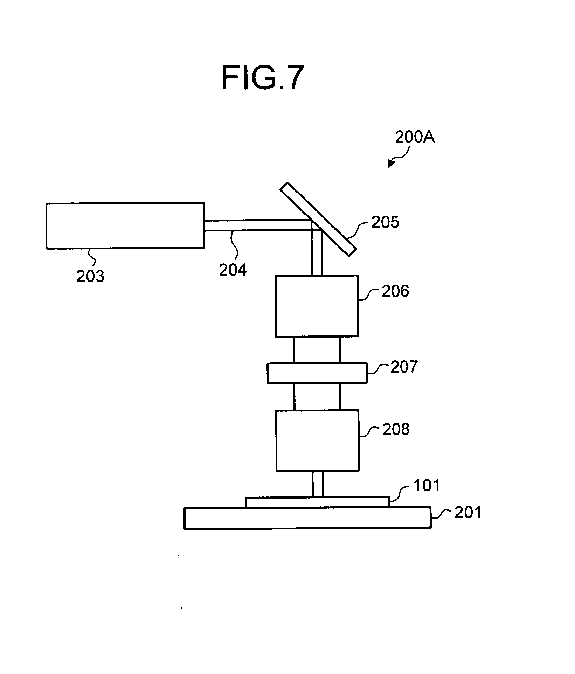

[Fig. 7] Fig. 7 is a schematic diagram of an example of a configuration of a laser processing device that forms openings.

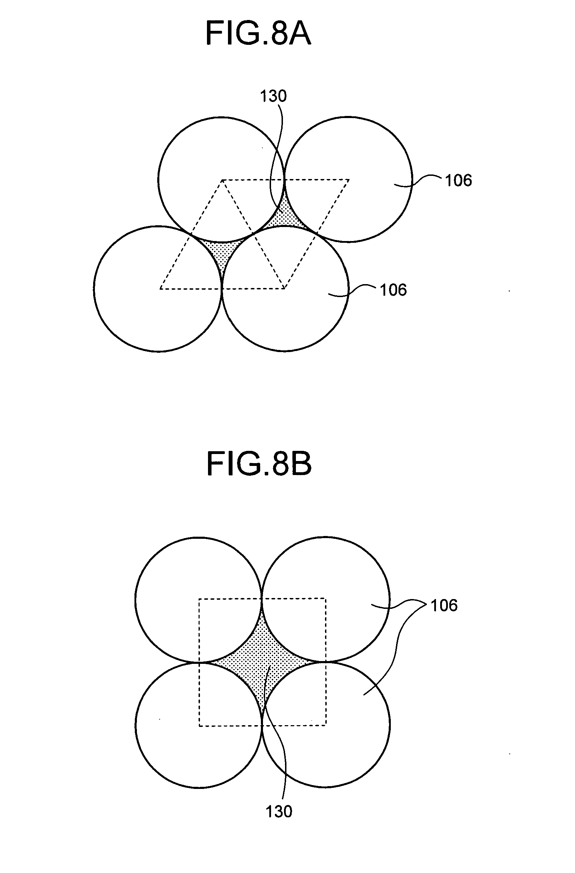

[Fig. 8-1] Fig. 8-1 is a schematic diagram of a surface shape after performing texture etching when openings are provided on triangular lattice points.
[Fig. 8-2] Fig. 8-2 is a schematic diagram of a surface shape after performing texture etching when openings are provided on square lattice points.

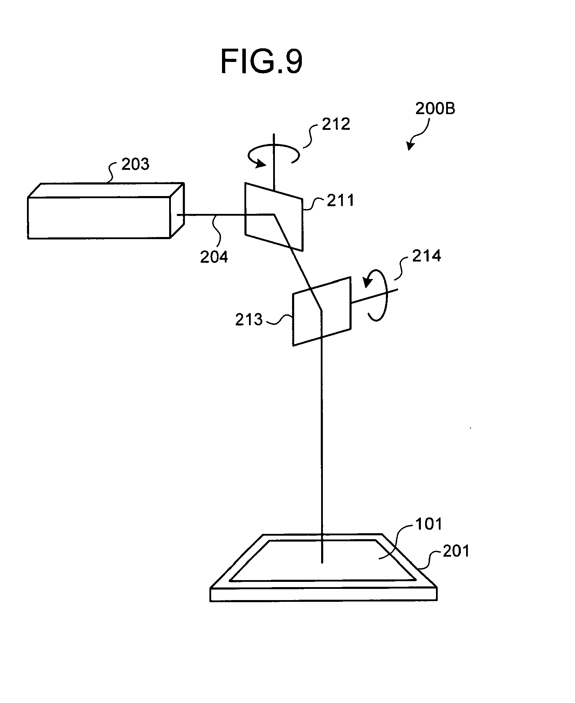

[Fig. 9] Fig. 9 is an example of a configuration of a laser processing apparatus used to form openings of a third embodiment.

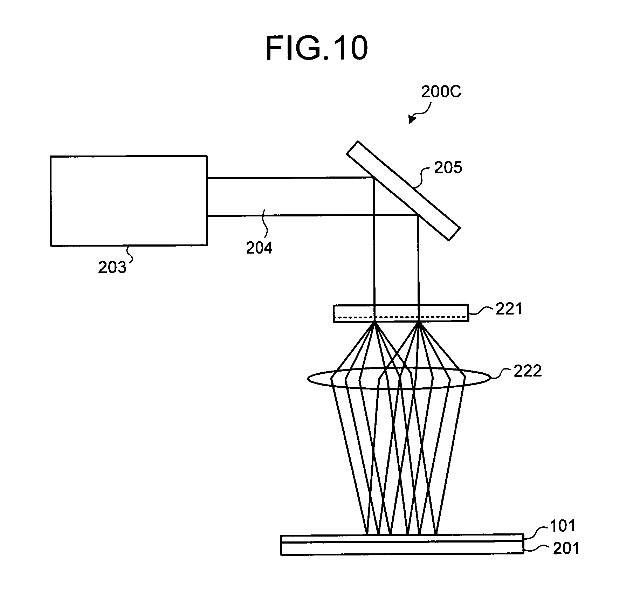

[Fig. 10] Fig. 10 is an example of a configuration of a laser processing apparatus used to form openings in a fourth embodiment.

### EXPLANATIONS OF LETTERS OR NUMERALS

- 100: photovoltaic power device
- 101: silicon substrate
- 102: N-type diffusion layer
- 102L: low-resistance N-type diffusion layer
- 102H: high-resistance N-type diffusion layer
- 103: etching resistance film
- 104: opening
- 105a: texture-structure forming region
- 105b: electrode forming region
- 106: concave portion
- 109: reflection prevention film
- 110: P+ layer
- 111: grid electrode
- 112: junction portion
- 113: bus electrode
- 121: backside electrode
- 122: backside collecting electrode
- 200A, 200B, 200C: laser processing apparatus
- 201: stage
- 203: laser oscillator
- 204: laser beam
- 205: reflection mirror
- 206: beam splitter
- 207: aperture
- 208: reduction optical system
- 211,: 213 galvanomirror
- 212: X-axis direction
- 214: Y-axis direction
- 221: holographic optical element
- 222: collecting lens

### BEST MODE(S) FOR CARRYING OUT THE INVENTION

Exemplary embodiments of a photovoltaic power device and a manufacturing method thereof according to the present invention will be explained below in detail with reference to the accompanying drawings. The present invention is not limited to the embodiments. In addition, cross-sectional views of the photovoltaic power device explained in the following embodiments are only schematic, and the relationship between thickness and width and the ratio of thickness of each layer shown in the drawings are different from actual products.

### First embodiment.

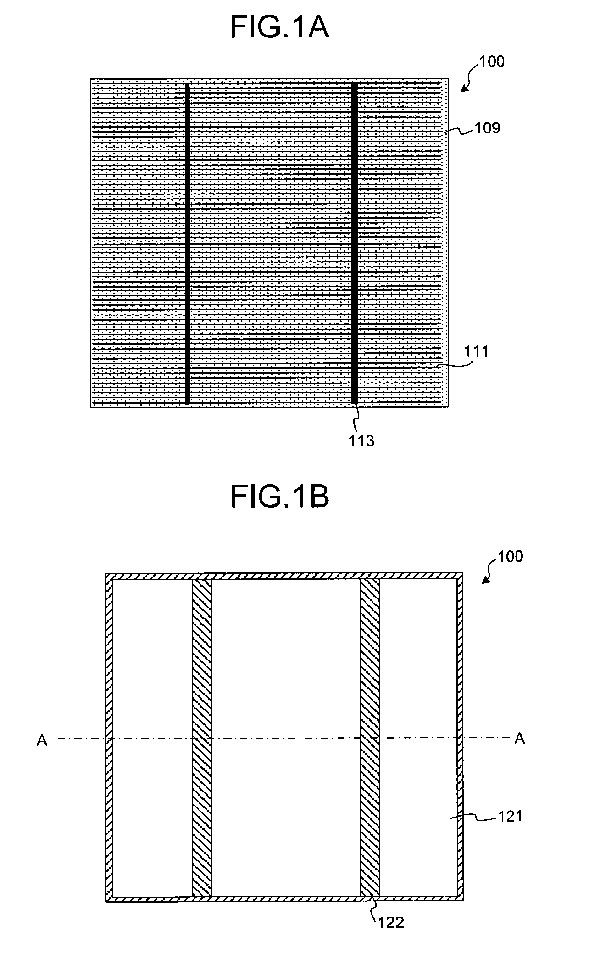

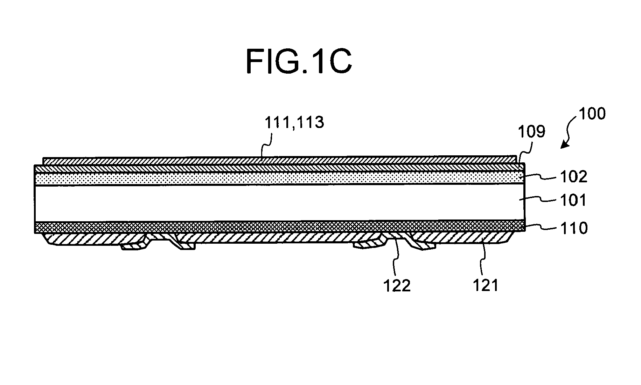

First, prior to explanations of a configuration of a photovoltaic power device according to a first embodiment of the present invention, an outline of an entire configuration of a general photovoltaic power device is explained. Figs. 1-1 to 1-3 are schematic views of an example of an entire configuration of a general photovoltaic power device, where Fig. 1-1 is a top view of the photovoltaic power device, Fig. 1-2 is a back view of the photovoltaic power device, and Fig. 1-3 is a cross-sectional view along A-A in Fig. 1-2. A photovoltaic power device 100 includes a photoelectric conversion layer including a P-type silicon substrate 101 as a semiconductor substrate, an N-type diffusion layer 102 diffused with an N-type impurity formed on a surface at one principal surface (a light receiving surface) side of the P-type silicon substrate 101, and a P+ layer 110 containing a P-type impurity in a higher concentration than that of the silicon substrate 101 formed on a surface at a side of the other principal surface (a back surface). The photovoltaic power device 100 also includes a reflection prevention film 109 preventing a reflection of incident light to a light receiving surface of the photoelectric conversion layer, grid electrodes 111 made of silver or the like provided on the light receiving surface to locally collect electricity generated in the photoelectric conversion layer, bus electrodes 113 made of silver or the like provided substantially orthogonally with the grid electrodes 111 to extract electricity collected by the grid electrodes 111, backside electrodes 121 made of aluminum or the like provided on substantially the whole surface of the back surface of the P-type silicon substrate 101 to extract electricity generated in the photoelectric conversion layer and to reflect incident light, and backside collecting electrodes 122 made of silver or the like to collect electricity generated in the backside electrodes 121.

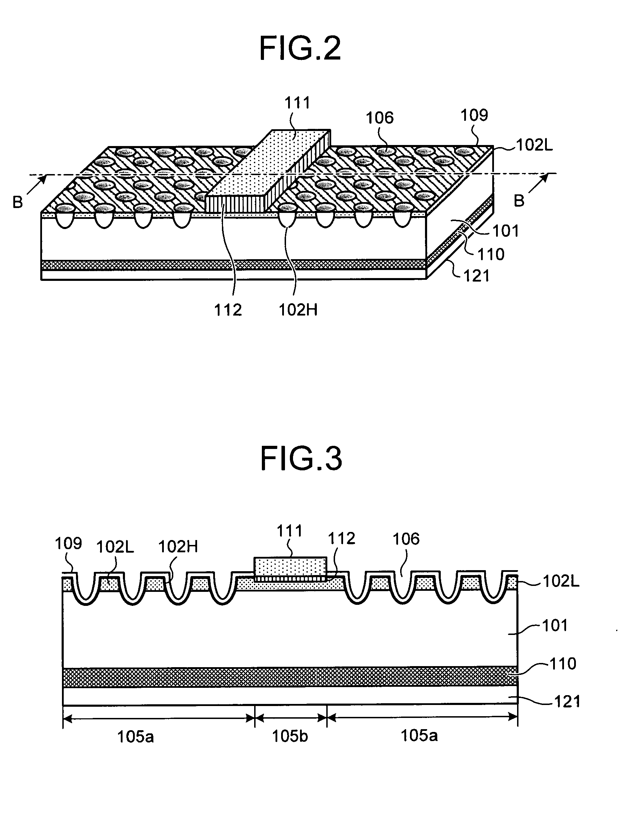

Characteristic parts of the first embodiment are explained next. Fig. 2 is a partial enlarged perspective view of a grid electrode periphery of the photovoltaic power device shown in Figs. 1-1 to 1-3, and Fig. 3 is a cross-sectional view along B-B in Fig. 2. Figs. 2 and 3 depict a cutout state of a periphery of the grid electrodes 111 in Figs. 1-1 to 1-3.

As shown in Figs. 2 and 3, a light receiving surface of the photovoltaic power device 100 has a texture-structure forming region 105a in which a texture structure having concave portions 106 at a predetermined interval is formed, and an electrode forming region 105b in which light-incidence-side electrodes such as the grid electrodes 111 of the photovoltaic power device 100 are formed.

The texture-structure forming region 105a has a low-resistance N-type diffusion layer 102L in which an N-type impurity is diffused in a high concentration, and a high-resistance N-type diffusion layer 102H in which an N-type impurity is diffused in a low concentration to have a higher resistance than that of the low-resistance N-type diffusion layer 102L. More specifically, the texture-structure forming region 105a has the concave portions 106 formed at a predetermined interval to reach the silicon substrate 101 from an upper surface of the low-resistance N-type diffusion layer 102L, in the low-resistance N-type diffusion layer 102L. The low-resistance N-type diffusion layer 102L is left in approximately a meshed shape at portions corresponding to surface portions of the silicon substrate 101 on which the concave portions 106 are not formed. The high-resistance N-type diffusion layer 102H is formed at a predetermined depth from an internal surface of each of the concave portions 106. A diameter of each of the concave portions 106 is set smaller than a distance between centers of adjacent concave portions 106. In the electrode forming region 105b, the light-incidence-side electrodes such as the grid electrodes 111 are formed via a junction portion 112 on the low-resistance N-type diffusion layer 102L. With this arrangement, a portion in which the low-resistance N-type diffusion layer 102L within the texture-structure forming region 105a remains in approximately a meshed shape and the electrode forming region 105b are continuously connected. Surface resistances (sheet resistances) of the low-resistance N-type diffusion layer 102L and the high-resistance N-type diffusion layer 102H are described later. Structures of the light receiving surface and the back surface of the silicon substrate 101 are identical to those explained with reference to Figs. 1-1 to 1-3, and therefore explanations thereof will be omitted.

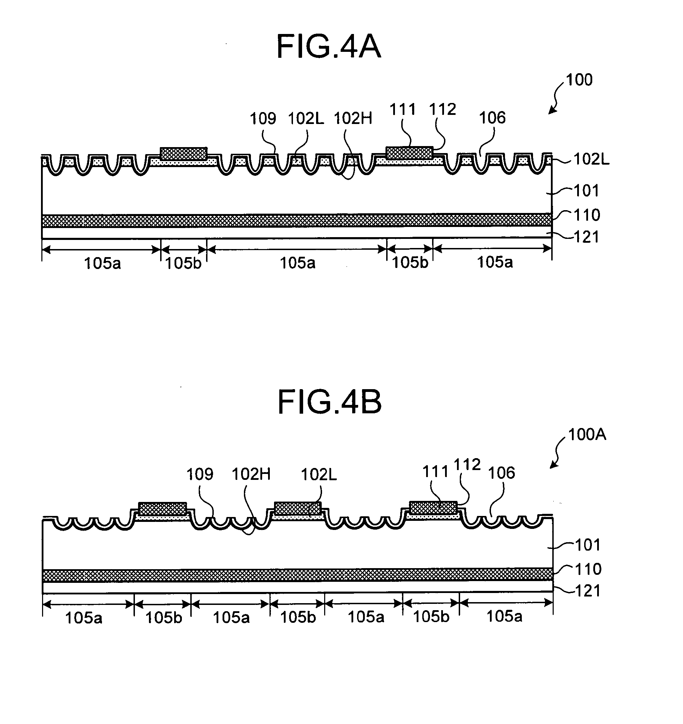

A difference between the photovoltaic power device 100 according to the first embodiment and a conventional photovoltaic power device is explained next. Fig. 4-1 is a cross-sectional view of an example of a structure of a grid electrode periphery of the photovoltaic power device according to the first embodiment, and Fig. 4-2 is an example of a structure of a grid electrode periphery of a conventional photovoltaic power device. In the conventional photovoltaic power device, constituent elements identical to those described in the first embodiment are denoted by like reference numerals.

As shown in Fig. 4-2, according to a conventional photovoltaic power device 100A, the low-resistance N-type diffusion layer 102L is formed on only a surface of the silicon substrate 101 in the electrode forming region 105b at a light-receiving surface side, and the high-resistance N-type diffusion layer 102H is formed on the whole surface of the texture-structure forming region 105a. A position of the surface (an upper surface) of the silicon substrate 101 in the texture-structure forming region 105a is retreated as compared with a position of the surface (an upper surface) of the silicon substrate 101 in the electrode forming region 105b due to formation of the concave portions 106. This structure is arranged for the following reasons. That is, the low-resistance N-type diffusion layer 102L, that is, a region where an impurity is diffused in a high concentration, has a considerably poor photoelectric conversion characteristic, and cannot effectively use sunlight incident at this portion. Therefore, in the region where sunlight is incident, it is better to form the high-resistance N-type diffusion layer 102H having a low impurity-concentration with a satisfactory photoelectric conversion characteristic. However, although the high-resistance N-type diffusion layer 102H has a satisfactory photoelectric conversion characteristic, a resistance loss of a photocurrent generated by the high resistance that turns to be heat is large. Consequently, an interval between adjacent grid electrodes 111 needs to be narrowed. Narrowing the interval between the grid electrodes 111 means an increase in an installation area of the grid electrodes 111, and forms shades to incident light entering the inside of the silicon substrate 101, thereby degrading the photoelectric conversion efficiency.

On the other hand, according to the photovoltaic power device 100 of the first embodiment, as shown in Fig. 2, Fig. 3, and Fig. 4-1, the concave portions 106 are provided at a predetermined interval to leave the low-resistance N-type diffusion layer 102L at the light-receiving surface side of the silicon substrate 101, and the high-resistance N-type diffusion layer 102H is provided in a range of a predetermined depth from the surface of each of the concave portions 106. The concave portions 106 can decrease the reflection ratio of incident sunlight, and the high-resistance N-type diffusion layer 102H in the concave portions 106 can efficiently convert the incident sunlight into a photocurrent. Further, because the photocurrent generated by the incidence of sunlight flows to the grid electrodes 111 through the low-resistance N-type diffusion layer 102L of an approximately a mesh shape left on the surface of the silicon substrate 101, the loss due to a resistance of the photocurrent can be reduced. Further, because the photocurrent is carried to the grid electrodes 111 via the low-resistance N-type diffusion layer 102L, the interval between the grid electrodes 111 can be taken longer than those of the conventional example shown in Fig. 4-2. With this arrangement, the area of shades to light incident to the inside of the silicon substrate 101 of the grid electrodes 111 can be decreased and the photoelectric conversion efficiency can be increased as compared with the conventional example.

A manufacturing method of the photovoltaic power device in this structure is explained next. Figs. 5-1 to 5-9 are schematic perspective views of an example of a process procedure of the manufacturing method of a photovoltaic power device according to the first embodiment, and Figs. 6-1 to 6-9 are cross-sectional views along B-B in Figs. 5-1 to 5-9, respectively. Sizes mentioned below are only examples.

First, the silicon substrate 101 is prepared (Fig. 5-1, Fig. 6-1). It is assumed here that a P-type polycrystalline silicon substrate most used for a household photovoltaic power device is used. The silicon substrate 101 is manufactured by slicing a polycrystalline silicon ingot with a multiwire saw, and by removing damage at a slicing time by wet etching using an acid or alkali solution. The thickness of the silicon substrate 101 after removing the damage is 250 micrometers, and dimension is 150 mm×150 mm.

Next, the silicon substrate 101 after removing its damage is input to a thermal oxidation furnace, and is heated in an atmosphere of phosphorus (P) as an N-type impurity. Phosphorus is diffused to the surface of the silicon substrate 101 in a high concentration, thereby forming the low-resistance N-type diffusion layer 102L (Fig. 5-2, Fig. 6-2). In this case, phosphorous oxychloride (POCl₃) is used to form a phosphorous atmosphere, and is diffused at 840°C.

Thereafter, a film having an etching resistance (hereinafter, "etching resistance film") 103 is formed on the low-resistance N-type diffusion layer 102L formed on one principal surface (Fig. 5-3, Fig. 6-3). A silicon nitride film (hereinafter, "SiN film"), a silicon oxide (SiO₂ SiO) film, a silicon oxynitride (SiON) film, an amorphous silicon (a-Si) film, a diamond-like carbon film, and a resin film can be used for the etching resistance film 103. In this case, an SiN film with a film thickness of 240 nanometers formed by a plasma CVD (Chemical Vapor Deposition) method is used for the etching resistance film 103. Although the film thickness is set at 240 nanometers, the proper film thickness can be selected based on etching conditions at a texture etching time and based on removability of the SiN film in the following processes.

Next, openings 104 are formed in the texture-structure forming region 105a on the etching resistance film 103 (Fig. 5-3, Fig. 6-3). The openings 104 are not formed in the electrode forming region 105b in which light-incidence-side electrodes of the photovoltaic power device 100 are formed without forming the texture structure. In forming the openings 104, a method according to photolithography used in a semiconductor process and a method according to laser irradiation can be used. The method according to laser irradiation does not require a complex process of resist coating, exposure, development, etching, and resist removal necessary when the openings are formed by the photolithography technique. This has an advantage of being able to form the openings 104 by only irradiating laser beams and being able to simplify the process.

Fig. 7 is a schematic diagram of an example of a configuration of a laser processing device that forms openings. The laser processing apparatus 200A includes a stage 201 on which an object to be processed such as the silicon substrate 101 is mounted, a laser oscillator 203 that outputs a laser beam 204, a reflection mirror 205 that guides the laser beam 204 to an optical path by reflecting the laser beam 204, a beam splitter 206 that splits the laser beam 204 into plural laser beams, an aperture 207 that forms a beam shape in a predetermined shape, and a reduction optical system 208 that reduces the laser beam 204 passed through the aperture 207 and irradiates the reduced laser beam to the object to be processed.

In the laser processing apparatus 200A, the laser beam 204 output from the laser oscillator 203 is enlarged by the beam splitter 206 after an optical path is changed by the reflection mirror 205, and is input to the aperture 207. After passing through the aperture 207, the laser beam 204 is irradiated to a predetermined position on the etching resistance film 103 by the reduction optical system 208. As a result, plural openings 104 as fine pores are formed in the etching resistance film 103 formed on the silicon substrate 101, and a surface of the silicon substrate 101 of a ground (the low-resistance N-type diffusion layer 102L) is exposed.

A combination of Nd:YAG (Yttrium Aluminum Garnet) laser and a triple harmonic generator is used for the laser oscillator 203. As a result, a wavelength of a laser beam becomes 355 nanometers which can be absorbed by the SiN film. A focal depth of the optical system is set at or higher than 10 micrometers. By selecting strength of a laser beam capable of forming concaves on the silicon substrate 101 of the ground after removing the SiN film, the ratio of a concave depth to a concave diameter can be set large and its light confinement effect can be enhanced. It is made clear by experiment that an opening can be formed on the SiN film at or above 0.4 J/cm², and concaves can be formed on the silicon substrate 101 of the ground at or above 2 J/cm². Therefore, laser beam intensity of 3 J/cm² is used here. Although a triple harmonic wave of the Nd:YAG laser is used for a laser beam source, other laser beam source can be also used when the laser beam source can output a laser beam of a wavelength shorter than 700 nanometers at which damage to the silicon substrate 101 due to a laser beam can be suppressed within 4 micrometers which is within a texture etching depth.

Further, a metal sheet formed with an opening is used for the aperture 207 in the laser processing apparatus 200A described above. Because the laser beam 204 passed through the aperture 207 is reduced and is irradiated to an object to be processed, an opening pattern of the aperture 207 can be relatively large. Therefore, a metal sheet formed with an opening by using wet etching or sandblasting can be also used for the aperture 207. A glass mask having a thin-film metal pattern of a chrome film or the like formed on a glass sheet can be also used for the aperture 207. In this case, it is necessary to pay attention to the transmission ratio of glass and the resistance of a metal thin film.

Next, a portion near the surface of the silicon substrate 101 including the low-resistance N-type diffusion layer 102L is etched through the openings 104 formed on the etching resistance film 103, thereby forming the concave portions 106 (Fig. 5-5, Fig. 6-5). Because this etching is performed on the silicon substrate 101 through fine openings 104, the concave portions 106 are formed at a concentric position around each fine opening 104 on the surface of the silicon substrate 101. When etching is performed by using an etching liquid of a mixed acid system, a uniform texture is formed without being influenced by a crystal surface orientation of the surface of the silicon substrate 101, and the photovoltaic power device 100 with a smaller surface-reflection loss can be manufactured. In this case, a mixed liquid of hydrofluoric acid and nitric acid is used for the etching liquid. The mixing ratio of hydrofluoric acid, nitric acid, and water is 1:20:10. The mixing ratio of the etching liquid can be changed to a proper mixing ratio based on desired etching speed and a desired etching shape. Although the low-resistance N-type diffusion layer 102L is formed at a substrate surface side on the surface of the concave portions 106 formed by this etching, no impurity is introduced into a region deeper than this.

Further, when the concave portions 106 is formed by this etching, although substantially the whole of the low-resistance N-type diffusion layer 102L at a light-incidence surface side is conventionally removed as shown in Fig. 4-2, the low-resistance N-type diffusion layer 102L between adjacent concave portions 106 is intentionally left in this case as shown in Fig. 5-5 and Fig. 6-5, thereby guiding a photocurrent generated on a light incidence surface to light-incidence-side electrodes (the grid electrodes 111) through the low-resistance N-type diffusion layer 102L as a low-resistance current path.

Next, after the etching resistance film 103 is removed by using hydrofluoric acid or the like (Fig. 5-6, Fig. 6-6), the silicon substrate 101 is input to the thermal oxidation furnace again, and is heated in the presence of phosphorous oxychloride (POCl₃) vapor, thereby forming the high-resistance N-type diffusion layer 102H having phosphorus diffused in a low concentration on the surface of the concave portions 106 (Fig. 5-7, Fig. 6-7). A diffusion temperature in this case is set at 840°C. Because the electrode forming region 105b is a portion in which the low-resistance N-type diffusion layer 102L remains at the etching time, the resistance remains low even when diffusion in a low concentration is performed again on this portion. Although an internal surface of the concave portions 106 in the texture-structure forming region 105a is in a state that the low-resistance N-type diffusion layer 102L is removed at the etching time, the high-resistance N-type diffusion layer 102H is formed by this diffusion process.

When the sheet resistance of the low-resistance N-type diffusion layer 102L becomes lower, contact with the electrodes becomes more satisfactory, a large layout interval between the grid electrodes 11 can be taken, and influence of shades to the silicon substrate 101 attributable to the layout of the grid electrodes 111 can be suppressed. However, to decrease the resistance, a heating time at the diffusion time needs to be set longer or a heating temperature needs to be increased. These processes become a cause of degrading the quality of polycrystalline silicon (the silicon substrate 101). As explained above, because decrease in the resistance of the low-resistance N-type diffusion layer 102L and the quality of the silicon substrate 101 are in a tradeoff relationship, a heating process of the silicon substrate 101 needs to be performed under a condition that the resistance becomes the sheet resistance of the low-resistance N-type diffusion layer 102L corresponding to a characteristic required by the photovoltaic power device 100 to be manufactured. Generally, the surface sheet resistance of the low-resistance N-type diffusion layer 102L is preferably equal to or higher than 30 Ω and lower than 60 Ω/. However, considering also mass productivity, the surface sheet resistance of the low-resistance N-type diffusion layer 102L is preferably equal to or higher than 45 Ω/ and lower than 55 Ω/. Generally, the surface sheet resistance of the high-resistance N-type diffusion layer 102H is preferably equal to or higher than 60 Ω/ and lower than 150 Ω/. However, considering stability of a characteristic at a mass production time, the surface sheet resistance of the high-resistance N-type diffusion layer 102H is preferably equal to or higher than 70 Ω/ and lower than 100 Ω/.

Next, a phosphorus glass layer formed by heating in the presence of phosphorous oxychloride (POCl₃) vapor is removed in a hydrofluoric acid solution. Thereafter, the reflection prevention film 109 made of an SiN film or the like is formed on a cell surface by a plasma CVD method (Fig. 5-8, Fig. 6-8). The film thickness and refractive index of the reflection prevention film 109 are set at values at which light reflection is most suppressed. A film in two or more layers having different refractive indexes can be also stacked. The reflection prevention film 109 can be also formed by a different film formation method such as a sputtering method.

Thereafter, surface electrodes (the grid electrodes 111 and the bus electrodes 113) and back surface electrodes (the backside electrodes 121 and the backside collecting electrodes 122) are formed. In this case, first, a paste mixed with aluminum is formed on the whole surface by screen printing for the backside electrodes 121. Next, a paste mixed with silver is formed by screen printing in a comb shape for the grid electrodes 111 (the bus electrodes 113). A sintering process is then performed. The paste as a basis of the grid electrodes 111 is formed on the electrode forming region 105b. The sintering process is performed at 760°C in atmosphere. In this case, the grid electrodes 111 are in contact with the low-resistance N-type diffusion layer 102L by piercing through the reflection prevention film 109 at the junction portion 112. Consequently, the low-resistance N-type diffusion layer 102L can obtain a satisfactory resistant junction with upper electrodes (the grid electrodes 111 and the bus electrodes 113). Aluminum in the backside electrodes 121 is diffused to the silicon substrate 101 by sintering, and the P+ layer 110 is formed within a predetermined range from the back surface of the silicon substrate 101. The photovoltaic power device 100 is manufactured as described above.

At the time of forming the openings 104 on the etching resistance film 103 in the texture-structure forming region 105a in Fig. 5-4 and Fig. 6-4 described above, the openings 104 can be provided on triangular lattice points or can be provided on square lattice points. Fig. 8-1 is a schematic diagram of a surface shape after performing texture etching when openings are provided on triangular lattice points, and Fig. 8-2 is a schematic diagram of a surface shape after performing texture etching when openings are provided on square lattice points.

As shown in Fig. 8-1, when texture etching is performed by providing the openings 104 on the triangular lattice points, a proportion of an approximately flat portion (a flat part) 130 not formed with the concave portions 106 becomes about 9%, and 90% or more of sunlight incident to a light incidence surface of the photovoltaic power device 100 is incident to the concaves (the concave portions 106) formed by etching. Therefore, light can be effectively used.

Meanwhile, as shown in Fig. 8-2, when texture etching is performed by providing the openings 104 on the square lattice points, a proportion of the flat part 130 not formed with the concave portions 106 exceeds 21%. Therefore, from a viewpoint of effective use of light, this case is inferior to a case of forming the concave portions 106 on the triangular lattice points. However, because the number of opening points can be smaller than that when the triangular lattice points are formed, this case is superior from a viewpoint of a mass production. From the above, whether to provide openings on the triangular lattice points or to provide openings on the square lattice points is to be determined by a performance/cost ratio required by a photovoltaic power device to be manufactured.

According to the first embodiment, the low-resistance N-type diffusion layer 102L is provided in a range of a predetermined depth from the surface at the light-receiving surface side of sunlight. The concave portions 106 are provided at a predetermined interval in the texture-structure forming region 105a. The high-resistance N-type diffusion layer 102H of a high resistance is formed on the internal surface of the concave portions 106. Therefore, at the time of forming the grid electrodes 111 of a comb shape at the light-receiving surface side, light incident to the photovoltaic power device 100 is efficiently converted into a photocurrent, and the generated photocurrent is carried to the grid electrodes 111 via the low-resistance N-type diffusion layer 102L having a low resistance. That is, the resistance loss is suppressed as compared with the resistance loss when sunlight passes through the high-resistance N-type diffusion layer 102H. Consequently, the interval between the grid electrodes 111 formed at the light-receiving surface side can be expanded as compared with those of the photovoltaic power device 100 in the conventional structure. Because the photoelectric conversion efficiency is superior to that of the photovoltaic power device having the same dimension (area) as conventional dimension, the energy efficiency is excellent and an energy saving effect is obtained.

### Second embodiment.

In the explanations of the first embodiment, after the high-resistance N-type diffusion layer 102H is formed within the concave portions 106 in Fig. 5-7 and Fig. 6-7, the phosphorus glass layer in the low-resistance N-type diffusion layer 102L and on the high-resistance N-type diffusion layer 102H is removed in the hydrofluoric acid solution. Alternatively, the uppermost surface of the low-resistance N-type diffusion layer 102L and the high-resistance N-type diffusion layer 102H can be etched with a mixed liquid of hydrofluoric acid and nitric acid. The following process procedures are identical to those described in the first embodiment and thus explanations thereof will be omitted.

According to the second embodiment, after etching the phosphorus glass layer in the low-resistance N-type diffusion layer 102L and on the high-resistance N-type diffusion layer 102H, the uppermost surface of the diffusion layers 102L and 102H is etched with a mixed liquid of hydrofluoric acid and nitric acid. Therefore, carrier recombination speed in the N-type diffusion layer can be suppressed.

### Third embodiment.

In the third embodiment, there is explained a case of forming openings in a method different from that of the first embodiment. Fig. 9 is an example of a configuration of a laser processing apparatus used to form openings of the third embodiment. The laser processing apparatus 200B includes the stage 201 on which an object to be processed such as the silicon substrate 101 is mounted, the laser oscillator 203 that outputs the laser beam 204, a first galvanomirror 211 that is arranged between the stage 201 and the laser oscillator 203 and guides the laser beam 204 to an optical path while scanning in an X-axis direction 212, and a second galvanomirror 213 that guides the laser beam 204 reflected by the first galvanomirror 211 to the optical path while scanning in a Y-axis direction 214.

In the laser processing apparatus 200B having this configuration, the laser beam 204 collected in a spot shape is irradiated to a predetermined position of the etching resistance film 103 on the silicon substrate 101 to form the openings 104, by scanning with the first and second galvanomirrors 211 and 213. In this manner, by scanning the laser beam 204 in the X-axis direction 212 by rotating the first galvanomirror 211, and by scanning the laser beam 204 in the Y-axis direction 214 by rotating the second galvanomirror 213, the openings 104 can be formed at high speed in the whole region of the silicon substrate 101. Specifically, in the case of forming 10,000 openings 104 per one scanning line at 15 micrometers pitch by using a laser beam of a repetition frequency 500 kilohertz, a scanning frequency of the first galvanomirror 211 can be set at 50 hertz. On the other hand, to form openings in closest arrangement on a triangular lattice, an interval of scanning lines in the Y-axis direction 214 needs to be set at 13 micrometers. Therefore, the scanning speed in the Y-axis direction 214 on the silicon substrate 101 surface is set to 0.65 millimeter. In this manner, the openings 104 of a diameter 5 micrometers can be formed in closest arrangement of 15 micrometers pitch on the etching resistance film 103.

According to the third embodiment, the laser beam 204 can be irradiated by scanning the surface on the etching resistance film 103 as an object to be processed by using the first and second galvanomirrors 211 and 213. Therefore, the openings 104 can be provided at high speed by methods other than multipoint irradiation.

### Fourth embodiment.

In the fourth embodiment, there is explained a case of forming openings by a method different from that of the first embodiment. Fig. 10 is an example of a configuration of a laser processing apparatus used to form openings in the fourth embodiment. The laser processing apparatus 200C includes the stage 201 on which an object to be processed such as the silicon substrate 101 is mounted, the laser oscillator 203 that outputs the laser beam 204, the reflection mirror 205 that guides the laser beam 204 to an optical path by reflecting the laser beam 204, a holographic optical element 221, and a collecting lens 222.

In the laser processing apparatus 200C, one laser beam 204 output from the laser oscillator 203, guided by the reflection mirror 205, and input to the holographic optical element 221 can be irradiated to an object to be processed at a few hundred points simultaneously at a desired interval, by a light interference effect and by the collecting lens 222. By irradiating the laser beam 204 that can be simultaneously irradiated, onto the etching resistance film 103 of the silicon substrate 101 by scanning, a processing time of forming the openings 104 can be substantially shortened as compared with a processing time when the laser processing apparatuses 200A and 200B shown in Figs. 7 and 9 are used.

In this manner, by using the laser processing apparatus 200C using the holographic optical element 221, the openings 104 can be formed at remarkably high speed in the whole region of the silicon substrate 101. Specifically, by using a laser beam of a repetition frequency 20 kilohertz, a few dozens of seconds is sufficient to process the whole surface of the silicon substrate 101 of 150-mm angle. The openings 104 of a diameter of about 5 micrometers can be formed in closest arrangement of about 15 micrometers pitch on the etching resistance film 103 in this manner.

According to the fourth embodiment, because a plurality of the openings 104 can be formed on the etching resistance film 103 with one-shot laser pulse by using the holographic optical element 221, processing throughput is improved remarkably.

Although a case of using the P-type silicon substrate 101 for the silicon substrate 101 has been explained in the first to fourth embodiments, identical effects are also obtained in the photovoltaic power device 100 of an opposite conductivity type forming a P-type diffusion layer by using the N-type silicon substrate 101. Although polycrystalline silicon is used for a substrate, identical effects are also obtained by using a monocrystalline silicon substrate. Although the substrate thickness is set at 250 micrometers in this case, a substrate of which thickness is reduced to a self-maintainable level, such as about 50 micrometers, can be also used. Although the dimension is described as 150 mm×150 mm, it is only an example, and identical effects are also achieved when the dimension is larger or smaller than the above dimension. In addition, although a silicon substrate has been explained above as the substrate, the present invention is not limited to silicon substrates, and the first to fourth embodiments described above can be applied to semiconductor substrates in general.

### INDUSTRIAL APPLICABILITY

As described above, the photovoltaic power device according to the present invention is useful for solar batteries that generate power using sunlight.

## Claims

1. A photovoltaic power device comprising:
a first-conductivity-type semiconductor substrate;
a first diffusion layer diffused with a second-conductivity-type impurity in a first concentration formed at a light-incidence surface side of the semiconductor substrate;
comb-shaped grid electrodes and bus electrodes that connect the grid electrodes formed on the first diffusion layer;
a second diffusion layer of a first-conductivity type formed on a back surface facing a light incidence surface of the semiconductor substrate; and
a back surface electrode formed on the second diffusion layer, wherein
the photovoltaic power device has concave portions provided at a predetermined interval to reach the semiconductor substrate from an upper surface of the first diffusion layer,
an upper surface of a region between the concave portions adjacent with each other includes the first diffusion layer, and
a third diffusion layer diffused with a second-conductivity-type impurity in a second concentration, which is lower than the first concentration, is formed in a range of a predetermined depth from a formation surface of the concave portions.

2. The photovoltaic power device according to claim 1, wherein the concave portions are formed on triangular lattice points or on square lattice points.

3. The photovoltaic power device according to claim 1, wherein
a sheet resistance of the first diffusion layer is equal to or higher than 30 Ω/□ and lower than 60 Ω/□, and
a sheet resistance of the third diffusion layer is equal to or higher than 60 Ω/□ and lower than 150 Ω/□.

4. The photovoltaic power device according to claim 1, wherein a diameter of the concave portions is smaller than a distance between centers of the concave portions adjacent with each other.

5. A manufacturing method of a photovoltaic power device, comprising:
a first-diffusion-layer forming step of forming a first diffusion layer in a first concentration by diffusing a second-conductivity-type impurity at a light-incidence surface side of a first-conductivity-type semiconductor substrate;
an etching-resistance-film forming step of forming an etching resistance film having an etching resistance characteristic on the first diffusion layer;
a fine-pore forming step of forming fine pores at a predetermined position on the etching resistance film, thereby exposing the first diffusion layer;
a concave-portion forming step of forming concave portions by etching the first diffusion layer and the semiconductor substrate around an exposed position of the first diffusion layer; and
a second-diffusion-layer forming step of forming a second diffusion layer by diffusing a second-conductivity-type impurity in a second concentration, which is lower than the first concentration, on a surface on which the concave portions are formed.

6. The manufacturing method of a photovoltaic power device according to claim 5, wherein at the concave-portion forming step, etching is performed under a condition that the first diffusion layer between the fine pores adjacent with each other remains.

7. The manufacturing method of a photovoltaic power device according to claim 5, wherein at the fine-pore forming step, a formation process of fine pores is performed by using a laser beam of a wavelength absorbed by the etching resistance film.

8. The manufacturing method of a photovoltaic power device according to claim 7, wherein
at the etching-resistance-film forming step, an SiN film is formed as the etching resistance film, and
at the fine-pore forming step, a laser beam having a wavelength equal to or smaller than 700 nanometers is used.

9. The manufacturing method of a photovoltaic power device according to claim 7, wherein at the fine-pore forming step, a plurality of the fine pores are opened simultaneously on the etching resistance film by shielding a part of the laser beam with a mask.

10. The manufacturing method of a photovoltaic power device according to claim 7, wherein at the fine-pore forming step, a plurality of the fine pores are opened by scanning the laser beam on the etching resistance film by using a galvanomirror.

11. The manufacturing method of a photovoltaic power device according to claim 7, wherein at the fine-pore forming step, a plurality of the fine pores are opened by scanning the laser beam on the etching resistance film by using a holographic optical element.

12. The manufacturing method of a photovoltaic power device according to claim 7, wherein at the fine-pore forming step, the fine pores are formed on triangular lattice points or on square lattice points of the etching resistance film.
